# EUROPEAN PATENT SPECIFICATION

(11) **EP 1 445 344 B1**
(45) Date of publication and mention of the grant of the patent: **03.06.2009**
(21) Application number: 03250791.5
(22) Date of filing: 07.02.2003
(51) Int. Cl.: C23C 14/24, C23C 14/28, C23C 14/30

(54) **Physical vapor deposition apparatus and process**
PVD-Vorrichtung und Verfahren
Appareil et procede pour depot physique en phase vapeur

(43) Date of publication of application: 11.08.2004
(73) Proprietor: GENERAL ELECTRIC COMPANY, Schenectady, NY 12345 (US)
(72) Inventor: Darolia, Ramgopal, West Chester, Ohio 45069 (US); Corderman, Reed Roeder, Niskayuna, New York 12309 (US); Rigney, Joseph David, Milford, Ohio 45150 (US); Nardil, Richard Arthur, Jr., Scotia, New York 12302 (US); Weimer, Michael James, Loveland, Ohio 45140 (US)
(74) Representative: Illingworth-Law, William Illingworth

(56) References cited:
- EP-A- 1 008 669
- US-A- 4 403 002
- US-A- 5 296 274
- PATENT ABSTRACTS OF JAPAN vol. 1995, no. 02, 31 March 1995 (1995-03-31) & JP 06 322521 A (TOYOBO CO LTD), 22 November 1994 (1994-11-22)
- PATENT ABSTRACTS OF JAPAN vol. 017, no. 554 (C-1118), 6 October 1993 (1993-10-06) & JP 05 156438 A (NIKON CORP), 22 June 1993 (1993-06-22)

## Description

The present invention generally relates to coating apparatuses of the type used to deposit ceramic and metallic coatings. More particularly, this invention relates to a physical vapor deposition (PVD) apparatus and process for depositing a coating whose composition contains elements with relatively low and relatively high vapor pressures, such as a nickel aluminide alloyed with zirconium, hafnium, yttrium and/or cerium.

Components within the turbine, combustor and augmentor sections of gas turbine engines are susceptible to oxidation and hot corrosion attack, in addition to high temperatures that can decrease their mechanical properties. Consequently, these components are often protected by an environmental coating alone or in combination with an outer thermal barrier coating (TBC), which in the latter case is termed a TBC system.

Diffusion coatings, such as diffusion aluminides and particularly platinum aluminides (PtAl), and overlay coatings, particularly MCrAlX alloys (where M is iron, cobalt and/or nickel, and X is an active element such as yttrium or another rare earth or reactive element), are widely used as environmental coatings for gas turbine engine components. Ceramic materials such as zirconia (ZrO₂) partially or fully stabilized by yttria (Y₂O₃), magnesia (MgO) or other oxides, are widely used as TBC materials. Used in combination with TBC, diffusion aluminide and MCrAlX overlay coatings serve as a bond coat to adhere the TBC to the underlying substrate. The aluminum content of these bond coat materials provides for the slow growth of a strong adherent continuous aluminum oxide layer (alumina scale) at elevated temperatures. This thermally grown oxide (TGO) protects the bond coat from oxidation and hot corrosion, and chemically bonds the TBC to the bond coat.

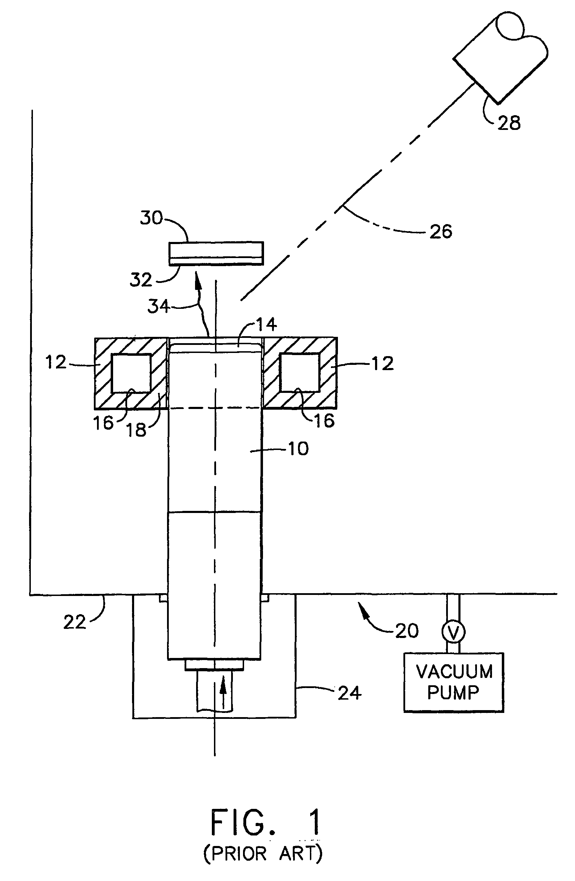

Suitable processes for depositing MCrAlX coatings include thermal spraying such as plasma spraying and high velocity oxyfuel (HVOF) processes, and physical vapor deposition (PVD) processes such as electron beam physical vapor deposition (EBPVD), magnetron sputtering, cathodic arc, ion plasma, and pulsed laser deposition (PLD). PVD processes require the presence of a coating source material made essentially of the coating composition desired, and means for creating a vapor of the coating source material in the presence of a substrate that will accept the coating. Figure 1 schematically represents a portion of an EBPVD coating apparatus 20, including a coating chamber 22 in which a component 30 is suspended for coating. An overlay coating 32 is represented as being deposited on the component 30 by melting and vaporizing an ingot 10 of the desired coating material with an electron beam 26 produced by an electron beam gun 28. The intensity of the beam 26 is sufficient to produce a stream 34 of vapor that condenses on the component 30 to form the overlay coating 32. As shown, the vapor stream 34 evaporates from a pool 14 of molten coating material contained within a reservoir formed by a crucible 12 that surrounds the upper end of the ingot 10. Water or another suitable cooling medium flows through cooling passages 16 defined within the crucible 12 to maintain the crucible 12 at an acceptable temperature. As it is gradually consumed by the deposition process, the ingot 10 is incrementally fed into the chamber 22 through an airlock 24.

More recently, overlay coatings (i.e., not a diffusion) of beta-phase nickel aluminide (βNiAl) intermetallic have been proposed as environmental and bond coat materials. The NiAl beta phase exists for nickel-aluminum compositions of about 30 to about 60 atomic percent aluminum, the balance of the nickel-aluminum composition being nickel. Notable examples of beta-phase NiAl coating materials include commonly-assigned U.S. Patent No. 5,975,852 to Nagaraj et al., which discloses a NiAl overlay bond coat optionally containing one or more active elements, such as yttrium, cerium, zirconium or hafnium, and commonly-assigned U.S. Patent No. 6,291,084 to Darolia et al., which discloses a NiAl overlay coating material containing chromium and zirconium. Commonly-assigned U.S. Patent Nos. 6,153,313 and 6,255,001 to Rigney et al. and Darolia, respectively, also disclose beta-phase NiAl bond coat and environmental coating materials. The beta-phase NiAl alloy disclosed by Rigney et al. contains chromium, hafnium and/or titanium, and optionally tantalum, silicon, gallium, zirconium, calcium, iron and/or yttrium, while Darolia's beta-phase NiAl alloy contains zirconium. The beta-phase NiAl alloys of Nagaraj et al., Darolia et al., Rigney et al., and Darolia have been shown to improve the adhesion of a ceramic TBC layer, thereby increasing the service life of the TBC system.

MCrAlY-type coatings have been deposited using PVD and thermal spray processes interchangeably to achieve acceptable levels of environmental protection. Although no advantages have been found for either deposition technique in terms of environmental performance, PVD processes have often been preferred for producing smooth as-coated surface finishes and coating thickness uniformity. In contrast, beta-NiAl coatings have been found to exhibit significantly improved spallation resistance and environmental properties if deposited by a PVD process. However, difficulties have been encountered when attempting to deposit beta-NiAl coatings alloyed with zirconium, hafnium, yttrium, cerium and/or another reactive element, as required by the NiAl compositions of Nagaraj et al., Darolia et al., Rigney et al., and Darolia. For example, when attempting to evaporate an ingot of NiAl+Zr or NiAl+Cr+Zr, deposition rates are low and the chemistry of the coating has been difficult to control.

PATENT ABSTRACTS OF JAPAN vol. 1995, no. 02, 31 March 1995 (1995-03-31) & JP 06 322521 A (TOYOBO CO LTD), 22 November 1994 (1994-11-22) discloses a continuous vapour deposition method in which the starting material for vapour deposition comprises at least two materials different in composition supplied continuously with respect to the heating source.

US-A-5296274 discloses a method of producing carbon-containing materials, in which coating of graphite mixed with another material is achieved by vaporizing more than one material onto a substrate.

The present invention is a PVD process and apparatus for depositing a coating from multiple sources of different materials. The process and apparatus are particularly intended to deposit a nickel-base intermetallic coating, such as the gamma phase .([Ni(Co,Fe,Cr,Mo,W,Re)]) or beta phase (βNiAl), which is alloyed to contain zirconium, hafnium, yttrium, cerium and/or another reactive element whose vapor pressure is significantly lower than the constituents of the nickel-base intermetallic. According to the invention, a different evaporation rate for these reactive elements is necessary to achieve higher deposition rates and better control of the coating chemistry.

According to the invention a physical vapor deposition apparatus comprises a coating chamber, means for providing at least two passages through which at least two materials may be fed into the coating chamber, at least a first of the materials having a composition with a higher vapor pressure than a second of the materials, means for melting the first and second materials to form molten pools thereof, and means for suspending an article within the coating chamber, the suspending means transporting the article within the coating chamber relative to the two molten pools so as to deposit a coating on the article with a controlled composition that is a mixture of the first and second materials. The first material may comprise beta-NiAl and the second material may be chosen from the group consisting of zirconium, hafnium, yttrium and cerium or other reactive element having a vapor pressure significantly lower than that of the beta phase Ni-Al material. The melting means is operable to melt the first and second materials at different rates and the power of the beam can be jumped to an appropriate level to optimize the melting and vaporizing rates of the particular material on which it is projected and comprises: a single beam provided with means for jumping the beam from one material to the other, means for controlling the amount of time that the beam is projected onto each of the materials and means for adjusting the amount of time on each material to obtain compositional control of the coating. The apparatus further comprises means for feeding the first and second materials into the chambers at different rates.

In a further embodiment of the invention there is a physical vapor deposition process comprising the steps of providing at least two passages through which at least two materials are fed into a coating chamber of a physical vapor deposition apparatus, at least a first of the materials having a composition with a higher vapor pressure than a second of the materials; melting the first and second materials to form molten pools thereof; suspending an article within the coating chamber and transporting the article relative to the two molten pools so as to deposit a coating on the article with a controlled composition that is a mixture of the first and second materials. The first material comprises beta-NiAl and the second material is chosen from the group consisting of zirconium, hafnium, yttrium and cerium or other reactive element having a vapor pressure significantly lower than that of the beta phase Ni-Al material. The step of melting the first and second materials includes melting the first and second materials at different rates and comprises jumping a single beam from one material to the other, controlling the amount of time that the beam is projected onto each of the materials, adjusting the amount of time on each material to obtain compositional control of the coating and feeding the first and second materials into the chambers at different rates. The power of the beam is jumped to an appropriate level to optimize the melting and vaporizing rates of the particular material on which it is projected.

As a result of the presence of two separate molten pools, a non-homogeneous vapor cloud is present within the chamber, necessitating that the article is transported relative to the two molten pools in order to deposit a coating with a controlled composition that is a mixture of the materials.

The above coating process has been demonstrated by depositing beta-phase nickel aluminide coating materials containing zirconium by EBPVD and sputtering, though it is expected that the invention is also applicable to other PVD processes and to combinations of PVD and the use of gaseous sources of minor alloying elements. The demonstrated process produced coatings with controlled chemistries, and at deposition rates higher than possible if a single ingot containing NiAl and zirconium were evaporated.

The invention will now be described in greater detail, by way of example, with reference to the drawings, in which:-
Figure 1 shows a schematic representation of a portion of a prior art EBPVD apparatus used to deposit a coating of a nickel-base intermetallic material.
Figures 2, 3 and 4 are schematic representations of portions of EBPVD apparatuses according to two embodiments of this invention.
Figure 5 is a graph comparing the performance potentials for coatings deposited by the EBPVD process of this invention with coatings deposited by a thermal spraying process.

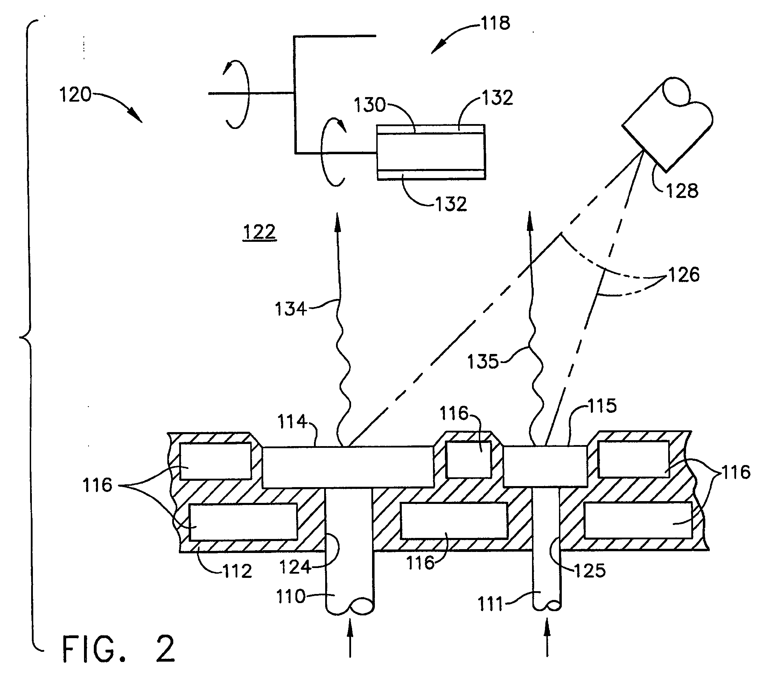

Three embodiments of a coating apparatus 120 are shown in Figures 2, 3 and 4 as being similar to the apparatus 20 of Figure 1, and representative of a type suitable for depositing nickel-base intermetallic coatings. A particularly preferred coating material that can be deposited with the coating apparatus 120 is a beta-phase nickel aluminide, though it is also foreseeable that gamma-phase nickel intermetallics could be deposited.

In Figure 2, the apparatus 120 is shown as comprising a crucible 112 through which a pair of ingots 110 and 111 are fed into a coating chamber 122, and an electron beam (EB) gun 128 generates an electron beam 126 that, in combination with a controlled beam jumping technique, melts the upper surfaces of both ingots 110 and 111 to produce separate molten pools 114 and 115 of the ingot materials within the crucible 112. With such a technique, the beam 126 is briefly projected (in the millisecond range) on each ingot 110 and 111, with the amount of time on each ingot 110 and 111 being adjusted so that the energy output achieves the energy balance required to obtain compositional control. As an alternative to the use of a single EB gun 128 according to the present invention as shown in Figure 2, two or more EB guns could be used to produce separate electron beams for maintaining both molten pools 114 and 115.

As with the apparatus 20 of Figure 1, a component 130 is suspended within the coating chamber 122, so that an overlay coating 132 is deposited on the component 130 as a result of the melting and vaporizing of the ingots 110 and 111, which produces streams 134 and 135 of vapors that condense on the component 130. The component 130 is supported on planetary tooling 118 that transports the component 130 over both pools 114 and 115, so that the overlay coating 132 is a mixture of the ingot materials. As they are gradually consumed by the deposition process, the ingots 110 and 111 are incrementally fed into the chamber 122 through separate passages 124 and 125 in the crucible 112. As known in the art, water or another suitable cooling medium preferably flows through cooling passages 116 defined within the crucible 112 to maintain the crucible 112 at an acceptable temperature.

According to a preferred aspect of the invention, the compositions of the ingots 110 and 111 are chosen so that the coating 132 is a beta-phase NiAl intermetallic material. Notable examples of NiAl-based materials are those disclosed in Nagaraj et al., Rigney et al., Darolia, and Darolia et al., discussed previously, which are formulated as environmental coatings and bond coats for gas turbine engine applications. These NiAl-based coatings preferably contain about 20 to 32 weight percent (about 35-50 atomic percent) aluminum to achieve the beta phase, and may contain one or more of chromium, hafnium, titanium, tantalum, silicon, gallium, zirconium, calcium, iron, cerium and/or yttrium. These alloying ingredients have different vapor pressures than beta-NiAl, which this invention has determined leads to limited deposition rates and difficulties in achieving controlled chemistries for the coating 132.

With the present invention, those alloying ingredients with significantly lower vapor pressures, most notably zirconium, hafnium, yttrium and cerium (or another reactive element), are provided in one of the ingots (e.g., 111), while those with higher vapor pressures, such as NiAl and chromium (if desired in the coating 132), are present in the other ingot (e.g., 110). The electron beam 126 is then used to melt and vaporize the ingots 110 and 111 at controlled but different rates to produce a coating 132 with a predictable chemistry. In particular, the power of the beam 126 is jumped to an appropriate level to optimize the melting and vaporizing rates of the particular ingot material on which it is projected, so that the overall deposition rate can be increased and the uniformity of the coating chemistry improved. The power level inputs to the pools 114 and 115 are adjusted based in part on the coating chemistry, in addition to the relative sizes of the pools 114 and 115. For ingots 110 and 111 of the same diameter, the required power level is lower for an ingot of zirconium and other reactive elements as compared to the NiAl ingot. Because of the different melting and vaporizing rates, the ingots 110 and 111 are fed into the chamber 122 at different rates as they are gradually consumed by the deposition process. As an example of the above, deposition of an NiCrAl overlay coating containing about 1 weight percent zirconium has been performed using separate ingots (110 and 111) of beta-phase NiAl+Cr and Zr, in which the molten pool size of the zirconium ingot is maintained to have a surface area of nearly fifty percent smaller than the pool size of the NiAl+Cr ingot. A lower power level input is able to maintain the molten zirconium pool because of its smaller size as well as the lower vapor pressure of zirconium compared to NiAl and chromium.

While only two ingots 110 and 111 are shown in Figure 2, it is foreseeable that multiple crucibles with multiple ingots of each type of material could be employed to increase the size of the coating zone within the chamber 122. Also foreseeable is the use of ingots containing multiple constituents of the coating 132 (e.g., nickel, aluminum and chromium) that are present in separate regions of the ingot. Another alternative is to use a separate ingot for each of the elements desired for the coating 132. For example, for a coating 132 of NiAl alloyed with chromium and zirconium, four separate nickel, aluminum, chromium and zirconium ingots could be used, each compositionally homogeneous and each individually melted to produce single-element pools that are co-evaporated. Again, the power levels of the electron beam used to evaporate the individual ingots would be controlled to optimize evaporation rates and promote the ability to obtain the desired chemistry for the coating 132.

In each of the different embodiments discussed above, the chemistry of the vapor cloud resulting from the vapor streams 134 and 135 will be quite different from one location to another within the cloud. Therefore, and particularly if multiple components or surfaces are to be coated at a single time, the location of the surfaces being coated within the vapor cloud will effect the coating chemistry. Therefore, the planetary tooling 118 shown in Figure 2 is preferably employed to achieve more uniform chemistry control by transporting the component 130 above both pools 114 and 115, so that the component 130 passes through those regions of the vapor cloud with different chemistries.

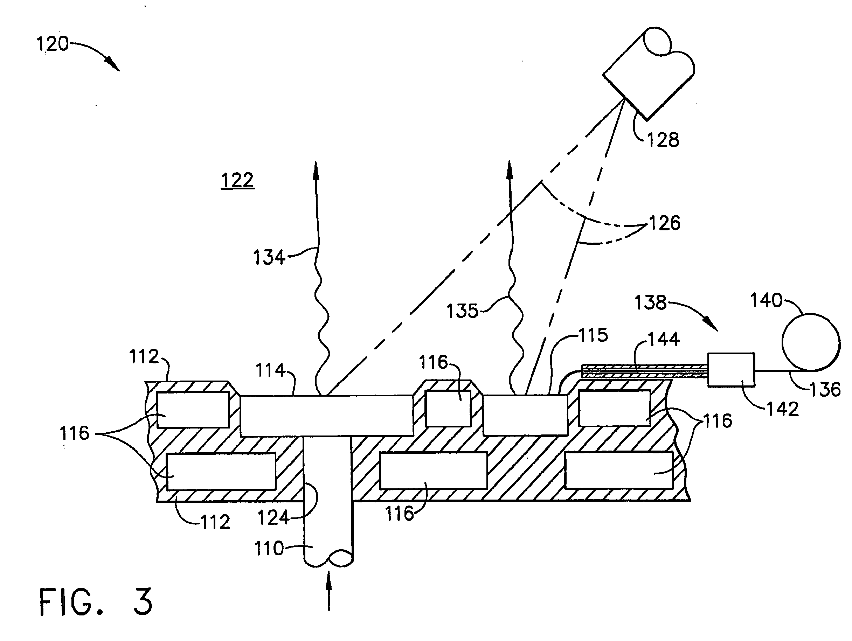

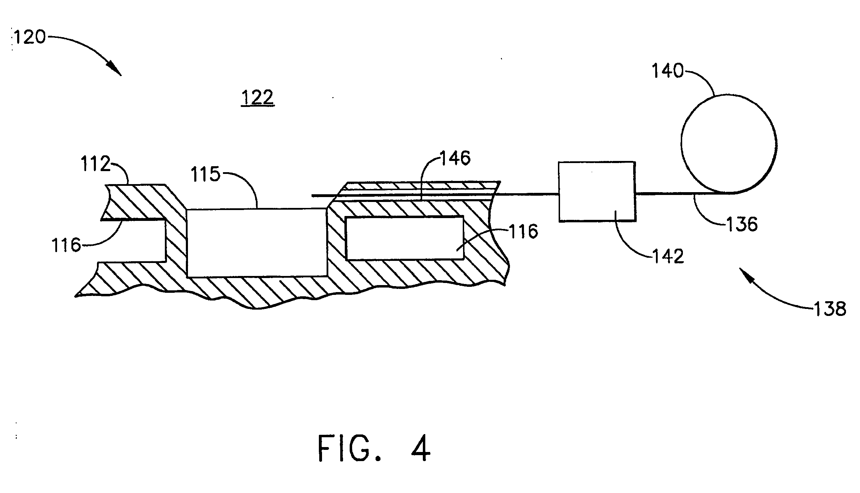

The embodiment of Figure 3 differs by modifying the crucible 112 to feed a wire 136 of the lower vapor pressure material into the chamber 122, instead of the ingot 111. The wire 136 is shown as being dispensed with a feed system 138 that includes a spool 140 from which the wire 136 is pulled by a wire feed device 142, which feeds the wire 136 through a guide 144 to the molten pool 115. Alternatively, the wire 136 could be fed by the wire feed device 142 through a passage 146 defined within the upper surface of the crucible 112, as shown in Figure 4. Other than appropriately modifying the control of the EB gun 128 to achieve a desired evaporation rate, the embodiments of Figures 3 and 4 are similar to that of Figure 2. An advantage of feeding a smaller diameter wire is the capability of a more accurate measurement of the higher volume feed rate made possible with this invention, as compared to the accuracy possible with an ingot that is larger in diameter, and therefore requires lower and more accurate linear feed rates as compared to a wire to achieve the same volume feed rate.

Various modifications could be made to the physical vapor deposition processes described above, including the use of a laser beam instead of an electron beam 126 to melt the ingots 110 and 111 or wire 136. Other physical vapor deposition techniques could also be used, including magnetron sputtering, cathodic arc, ion plasma, pulsed laser deposition (PLD), and combinations thereof. Particular combinations of PVD techniques include EBPVD with cathodic arc, EBPVD with ion plasma, EBPVD with sputtering, EBPVD with PLD, sputtering with PLD, and cathodic arc with PLD. In addition, a PVD technique could be combined with the use of a gaseous source of a minor alloying element, such as the reactive element (zirconium, hafnium, yttrium and/or cerium).

In an investigation leading to this invention, beta-phase NiAl-based coatings were deposited onto six sets of buttons made from the single-crystal superalloy known as René N5. The targeted composition for the coatings was, in atomic percent, about 40 to 48% aluminum, about 5% chromium, and about 0.1 to 1.2% zirconium. The EBPVD process used to deposit the coatings used an ingot of NiAlCr that was continuously melted and evaporated by one electron beam, while an ingot of zirconium was continuously melted and evaporated by a second electron beam. In this manner, ingot chemistry was used to obtain the relative desired levels of nickel, aluminum and chromium, while the electron beam parameters were adjusted to vary the zirconium content from one button set to another. During the coating process, the buttons were transported through the vapor cloud in a manner similar to that represented in Figure 2. The coatings were deposited to a thickness of about 2 mils (about 50 micrometers), after which the coated buttons were subjected to a vacuum diffusion heat treatment at about 1975°F (about 1080°C) for about two hours.

On a second set of René N5 buttons, NiAlCr+Zr coatings with compositions of, in atomic percent, about 47.4% aluminum, about 5% chromium, and about 0.2-0.4% zirconium were deposited to thicknesses of about 2 mils (about 50 micrometers) using a high velocity oxyfuel (HVOF) thermal spray process. The buttons were diffusion heat treated at about 1975°F (about 1080°C) for about two hours in a vacuum, after which their NiAlCr+Zr coatings were subjected to surface grinding to improve their surface finishes to below 100 microinches (about 2.5 micrometers) Ra, such that the HVOF coatings had surface finishes and coating thickness uniformity comparable to the EBPVD coatings.

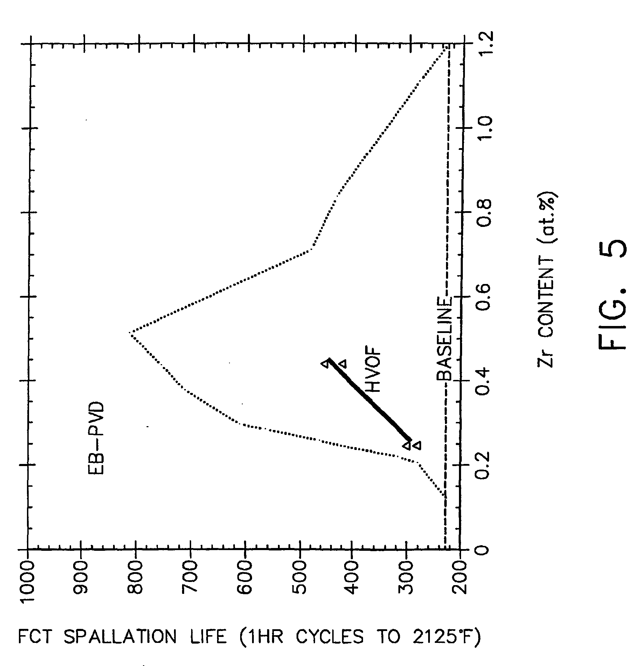

All of the buttons were then coated by EBPVD with about 5 mils (about 125 micrometers) of a thermal barrier coating (TBC) of 7%YSZ (zirconia stabilized by about 7 weight percent yttria), such that the NiAlCr+Zr coatings served as bond coats for the TBC. The spallation life potentials of the TBC coatings were then evaluated by furnace cycle testing (FCT) at a maximum temperature of about 2125°F (about 1160°C) using one-hour cycles. The results of the experiments are plotted in Figure 5. In addition to evidencing that FCT performance was strongly influenced by zirconium concentration, the plotted data show that the performance potentials for those coatings deposited by the PVD process not according to this invention were clearly superior those thermal sprayed coatings having the same bond coat chemistry.

In addition to achieving greater FCT performance as compared to coatings deposited by HVOF, the coating process of this invention was found to proceed more rapidly than when a single ingot containing the same composition desired for the coatings was evaporated with a single electron beam, essentially as depicted in Figure 1. Although the above results were obtained with NiAl-based coatings deposited by EBPVD, it is believed that similar results can also be achieved by depositing NiAl-based coatings by magnetron sputtering, as will as one or more of the other PVD processes noted above.

## Claims

1. A physical vapor deposition apparatus (120) comprising:
a coating chamber (122);
means (112) for providing at least two passages (124,125) through which at least two materials (110,111,136)may be fed into the coating chamber (122), at least a first (110) of the materials (110,111,136) having a composition with a higher vapor pressure than a second (111,136) of the materials (110,111,136);
means (126,128) for melting the first and second materials (110,111,136) to form molten pools (114,115) thereof, and
means (118) for suspending an article (130) within the coating chamber (122), the suspending means (118) transporting the article (130) within the coating chamber (122) relative to the two molten pools (114,115) so as to deposit a coating (132) on the article (130) with a controlled composition that is a mixture of the first and second materials (110,111,136);
wherein the melting means comprises: a single beam (126) provided with means for jumping the beam from one material to the other; means for controlling the amount of time that the beam is projected onto each of the materials, and means for adjusting the amount of time on each material to obtain compositional control of the coating; and
wherein said apparatus further comprises means for feeding the first and second materials into the chambers at different rates;
**characterised in that:**
the first material (110) may comprise beta-NiAl;
the second material (111,136) may be chosen from the group consisting of zirconium, hafnium, yttrium and cerium or other reactive element having a vapor pressure significantly lower than that of the beta phase Ni-Al material; and
the melting means (126,128) is operable to melt the first and second materials (110,111,136) at different rates and the power of the beam (126) can be jumped to an appropriate level to optimize the melting and vaporizing rates of the particular material on which it is projected.

2. A physical vapor deposition apparatus (120) according to claim 1, wherein the providing means (112) is a crucible (112) in which the two passages (124,125) are defined.

3. A physical vapor deposition apparatus (120) according to claim 1 or 2, wherein the melting means (126,128) comprises an electron beam (126) or a laser beam.

4. A physical vapor deposition apparatus (120) according to claim 1 or 2, wherein the melting means (126,128) is a single electron beam (126) that is sequentially projected on each of the first and second materials (110,111,136).

5. A physical vapor deposition process comprising the steps of:
providing at least two passages (124,125) through which at least two materials (110,111,136) are fed into a coating chamber (122) of a physical vapor deposition apparatus (120), at least a first (110) of the materials (110,111,136) having a composition with a higher vapor pressure than a second (111,136) of the materials (110,111,136);
melting the first and second materials (110,111,136) to form molten pools (114,115) thereof;
suspending an article (130) within the coating chamber (122) and transporting the article (130) relative to the two molten pools (114,115) so as to deposit a coating (132) on the article (130) with a controlled composition that is a mixture of the first and second materials (110,111,136);
the step of melting the first and second materials includes melting the first and second materials at different rates; and comprises jumping a single beam (126) from one material to the other; controlling the amount of time that the beam is projected onto each of the materials, and adjusting the amount of time on each material to obtain compositional control of the coating; and
feeding the first and second materials into the chambers at different rates;
**characterised in that:**
the first material (110) comprises beta-NiAl;
the second material (111,136) is chosen from the group consisting of zirconium, hafnium, yttrium and cerium or other reactive element having a vapor pressure significantly lower than that of the beta phase Ni-Al material; and
the power of the beam (126) is jumped to an appropriate level to optimize the melting and vaporizing rates of the particular material on which it is projected.

6. A physical vapor deposition process according to claim 5, wherein the two passages (124,125) are defined by a crucible (112).

7. A physical vapor deposition process according to claim 5 or 6, wherein the first and second materials (110,111,136) are melted with an electron beam (126) or a laser beam.

8. A physical vapor deposition process according to claim 5 or 6, wherein the first and second materials (110,111,136) are melted with a single electron beam (126) that is sequentially projected on each of the first and second materials (110,111,136).

## Patentansprüche

1. Vorrichtung (120) zur physikalischen Dampfabscheidung, aufweisend:
eine Beschichtungskammer (122);
Mittel (112) zum Bereitstellen von wenigstens zwei Kanälen (124, 125), durch die wenigstens zwei Materialien (110, 111, 136) in die Beschichtungskammer (122) eingeführt werden können, wobei wenigstens ein erstes (110) von den Materialien (110, 111, 136) eine Zusammensetzung mit einem höheren Dampfdruck als ein zweites (111, 136) von den Materialien (110, 111, 136) hat;
Mittel (126, 128) zum Schmelzen der ersten und zweiten Materialien (110, 111, 136), um deren Schmelzbäder (114, 115) auszubilden, und
Mittel (118) zum Aufhängen eines Gegenstandes (130) in der Beschichtungskammer (122), wobei die Aufhängungsmittel (118) den Gegenstand (130) in der Beschichtungskammer (122) in Bezug auf die zwei Schmelzbäder (114, 115) bewegen, um so eine Beschichtung (132) auf dem Gegenstand (130) mit einer gesteuerten Zusammensetzung abzuscheiden, die ein Gemisch der ersten und zweiten Materialien (110, 111, 136) ist;
wobei die Schmelzmittel aufweisen: einen Einzelstrahl (126), der mit Mitteln versehen ist, um den Strahl von einem Material zu dem anderen springen zu lassen; Mittel zum Steuern des Zeitlänge, die der Strahl auf jedes von den Materialien projiziert wird, und Mittel zum Einstellen der Zeitlänge auf jedem Material, um eine Zusammensetzungssteuerung der Beschichtung zu erhalten; und
wobei die Vorrichtung ferner Mittel zum Zuführen der ersten und zweiten Materialien in die Kammer mit unterschiedlichen Geschwindigkeiten aufweist;
**dadurch gekennzeichnet, dass:**
das erste Material (110) Beta-NiAl aufweisen kann;
das zweite Material (111, 136) aus der aus Zirkonium, Hafnium, Yttrium und Zer oder einem anderen reaktiven Element mit einem Dampfdruck deutlich niedriger als dem des Betaphasen Ni-Al-Materials bestehenden Gruppe ausgewählt werden kann; und
die Schmelzmittel (126, 118) so betreibbar sind, dass sie die ersten und zweiten Materialien (110, 111, 136) mit unterschiedlichen Geschwindigkeiten schmelzen und die Leistung des Strahls (126) sprungartig auf einen geeigneten Pegel eingestellt werden kann, um die Schmelz- und Verdampfungsraten des speziellen Materials, auf welches er gerichtet ist, zu optimieren.

2. Vorrichtung (120) zur physikalischen Dampfabscheidung nach Anspruch 1, wobei die Bereitstellungsmittel (112) ein Tiegel (112) sind, in welchem die zwei Kanäle (124, 125) definiert sind.

3. Vorrichtung (120) zur physikalischen Dampfabscheidung nach Anspruch 1 oder 2, wobei die Schmelzmittel (126, 128) einen Elektronenstrahl (126) oder einen Laserstrahl umfassen.

4. Vorrichtung (120) zur physikalischen Dampfabscheidung nach Anspruch 1 oder 2, wobei die Schmelzmittel ein einzelner Elektronenstrahl (126) sind, der sequentiell auf jedes von den ersten und zweiten Materialien (110, 111, 136) projiziert wird.

5. Verfahren zur physikalischen Dampfabscheidung mit den Schritten:
Bereitstellen von wenigstens zwei Kanälen (124, 125), durch welche wenigstens zwei Materialien (110, 111, 136) in eine Beschichtungskammer (122) einer Vorrichtung (120) zur physikalischen Dampfabscheidung eingeführt werden, wobei wenigstens ein erstes (110) von den Materialien (110, 111, 136) eine Zusammensetzung mit einem höheren Dampfdruck als das zweite (111, 136) von den Materialien (110, 111, 136) hat;
Schmelzen der ersten und zweiten Materialien (110, 111, 136), um deren Schmelzbäder (114, 115) auszubilden;
Aufhängen eines Gegenstandes (130) in der Beschichtungskammer (122) und Transportieren des Gegenstandes (130) in Bezug auf die zwei Schmelzbäder (114, 115), um so eine Beschichtung (132) auf dem Gegenstand (130) mit einer gesteuerten Zusammensetzung abzuscheiden, die ein Gemisch der ersten und zweiten Materialien (110, 111, 136) ist;
wobei der Schritt der Schmelzung der ersten und zweiten Materialien die Schmelzung der ersten und zweiten Materialien bei unterschiedlichen Geschwindigkeiten beinhaltet; und Schritte des Springens eines einzelnen Strahls (126) von einem Material zu dem anderen; der Steuerung der zeitlänge, die der Strahl auf jedes von den Materialien projiziert wird, und der Anpassung der Zeitlänge auf jedem Material aufweist, um eine Zusammensetzungssteuerung der Beschichtung zu erzielen; und
Zuführen der ersten und zweiten Materialien in die Kammer mit unterschiedlichen Geschwindigkeiten;
**dadurch gekennzeichnet, dass**
das erste Material (110) Beta-NiAl aufweist;
das zweite Material (111, 136) aus der aus Zirkonium, Hafnium, Yttrium und Zer oder einem anderen reaktiven Element mit einem Dampfdruck deutlich niedriger als dem des Betaphasen Ni-Al-Materials bestehenden Gruppe ausgewählt wird; und
die Leistung des Strahls (126) sprungartig auf einen geeigneten Pegel eingestellt wird, um die Schmelz- und Verdampfungsraten des speziellen Materials, auf welches er gerichtet ist, zu optimieren.

6. Verfahren zur physikalischen Dampfabscheidung nach Anspruch 5, wobei die zwei Kanäle (124, 125) durch einen Tiegel (112) definiert werden.

7. Verfahren zur physikalischen Dampfabscheidung nach Anspruch 5 oder 6, wobei die ersten und zweiten Materialien (110, 111, 136) mit einem Elektronenstrahl (126) oder einem Laserstrahl geschmolzen werden.

8. Verfahren zur physikalischen Dampfabscheidung nach Anspruch 5 oder 6, wobei die ersten und zweiten Materialien (110, 111, 136) mit nur einem Elektronenstrahl (126) geschmolzen werden, der sequentiell auf jedes von den ersten und zweiten Materialien (110, 111, 136) projiziert wird.

## Revendications

1. Appareil de dépôt physique en phase vapeur (120) comprenant :
une chambre de revêtement (122) ;
un moyen (112) pour fournir au moins deux passages (124, 125) à travers lesquels au moins deux matériaux (110, 111, 136) peuvent être chargés dans la chambre de revêtement (122), au moins un premier matériau (110) parmi les matériaux (110, 111, 136) ayant une composition avec une pression de vapeur supérieure à celle d'un deuxième matériau (111, 136) parmi les matériaux (110, 111, 136) ;
un moyen (126, 128) pour faire fondre les premier et deuxième matériaux (110, 111, 136) pour former des bassins en fusion (114, 115) de ceux-ci, et
un moyen (118) pour suspendre un article (130) à l'intérieur de la chambre de revêtement (122), le moyen de suspension (118) transportant l'article (130) à l'intérieur de la chambre de revêtement (122) par rapport aux deux bassins en fusion (114, 115) de façon à déposer un revêtement (132) sur l'article (130) avec une composition contrôlée qui est un mélange des premier et deuxième matériaux (110, 111, 136) ;
dans lequel le moyen de fusion comprend : un faisceau unique (126) équipé d'un moyen pour commuter le faisceau d'un matériau à l'autre ; un moyen pour contrôler la durée pendant laquelle le faisceau est projeté sur chacun des matériaux et un moyen pour ajuster la durée sur chaque matériau pour assurer un contrôle de la composition du revêtement ; et
dans lequel ledit appareil comprend en outre un moyen pour charger les premier et deuxième matériaux dans les chambres à différents débits ;
**caractérisé en ce que :**
le premier matériau (110) peut comprendre du bêta-NiAl ;
le deuxième matériau (111, 136) peut être choisi dans le groupe constitué par le zirconium, l'hafnium, l'yttrium et le cérium ou un autre élément réactif ayant une pression de vapeur significativement inférieure à celle du matériau de type Ni-Al en phase bêta ; et
le moyen de fusion (126, 128) peut fonctionner de façon à faire fondre les premier et deuxième matériaux (110, 111, 136) à différentes vitesses et la puissance du faisceau (126) peut être commutée vers un niveau approprié pour optimiser les vitesses de fusion et de vaporisation du matériau particulier sur lequel il est projeté.

2. Appareil de dépôt physique en phase vapeur (120) selon la revendication 1, dans lequel le moyen de fourniture (112) est un creuset (112) dans lequel les deux passages (124, 125) sont définis.

3. Appareil de dépôt physique en phase vapeur (120) selon la revendication 1 ou 2, dans lequel le moyen de fusion (126, 128) comprend un faisceau d'électrons (126) ou un faisceau laser.

4. Appareil de dépôt physique en phase vapeur (120) selon la revendication 1 ou 2, dans lequel le moyen de fusion (126, 128) comprend un faisceau d'électrons unique (126) qui est projeté séquentiellement sur chacun des premier et deuxième matériaux (110, 111, 136).

5. Procédé de dépôt physique en phase vapeur comprenant les étapes suivantes consistant à :
fournir au moins deux passages (124, 125) à travers lesquels au moins deux matériaux (110, 111, 136) sont chargés dans une chambre de revêtement (122) d'un appareil de dépôt en phase vapeur par un procédé physique (120), au moins un premier matériau (110) parmi les matériaux (110, 111, 136) ayant une composition avec une pression de vapeur supérieure à celle d'un deuxième matériau (111, 136) parmi les matériaux (110, 111, 136) ;
faire fondre les premier et deuxième matériaux (110, 111, 136) pour former des bassins en fusion (114, 115) de ceux-ci,
suspendre un article (130) à l'intérieur de la chambre de revêtement (122) et transporter l'article (130) par rapport aux deux bassins en fusion (114, 115) de façon à déposer un revêtement (132) sur l'article (130) avec une composition contrôlée qui est un mélange des premier et deuxième matériaux (110, 111, 136) ;
l'étape de fusion des premier et deuxième matériaux comprend la fusion des premier et deuxième matériaux à des vitesses différentes ; et elle comprend la commutation d'un faisceau unique (126) d'un matériau à l'autre ; le contrôle de la durée pendant laquelle le faisceau est projeté sur chacun des matériaux et l'ajustement de la durée sur chaque matériau pour assurer un contrôle de la composition du revêtement ; et
l'alimentation des premier et deuxième matériaux dans les chambres à différents débits ;
**caractérisé en ce que** :
le premier matériau (110) comprend du bêta-NiAl ;
le deuxième matériau (111, 136) est choisi dans le groupe constitué par le zirconium, l'hafnium, l'yttrium et le cérium ou un autre élément réactif ayant une pression de vapeur significativement inférieure à celle du matériau de type Ni-Al en phase bêta ; et
la puissance du faisceau (126) est commutée vers un niveau approprié pour optimiser les vitesses de fusion et de vaporisation du matériau particulier sur lequel il est projeté.

6. Procédé de dépôt physique en phase vapeur selon la revendication 5, dans lequel les deux passages (124, 125) sont définis par un creuset (112).

7. Procédé de dépôt physique en phase vapeur selon la revendication 5 ou 6, dans lequel les premier et deuxième matériaux (110, 111, 136) sont mis en fusion avec un faisceau d'électrons (126) ou avec un faisceau laser.

8. Procédé de dépôt physique en phase vapeur selon la revendication 5 ou 6, dans lequel les premier et deuxième matériaux (110, 111, 136) sont mis en fusion avec un faisceau d'électrons unique (126) qui est projeté séquentiellement sur chacun des premier et deuxième matériaux (110, 111, 136).
